Europäisches Patentamt

European Patent Office

Office européen des brevets

(19)

(11) Veröffentlichungsnummer: **0 346 599 B1**

(12) # EUROPÄISCHE PATENTSCHRIFT

(45) Veröffentlichungstag der Patentschrift: **19.05.93**

(51) Int. Cl.⁵: **C23C 14/34**

(21) Anmeldenummer: **89107319.9**

(22) Anmeldetag: **22.04.89**

(54) **Target für Magnetron − Kathodenzerstäubungsanlagen.**

(30) Priorität: **11.06.88 DE 3819906**

(43) Veröffentlichungstag der Anmeldung:
**20.12.89 Patentblatt 89/51**

(45) Bekanntmachung des Hinweises auf die
Patenterteilung:
**19.05.93 Patentblatt 93/20**

(84) Benannte Vertragsstaaten:
**AT BE CH DE ES FR GB GR IT LI LU NL SE**

(56) Entgegenhaltungen:
**EP − A − 0 252 478**

(73) Patentinhaber: **Degussa Aktiengesellschaft**
**Weissfrauenstrasse 9**
**W − 6000 Frankturt am Main 1(DE)**

(72) Erfinder: **Weigert, Martin, Dr. Dipl. − Phys.**
**Fürstenbergstrasse 6**
**W − 6450 Hanau 9(DE)**
Erfinder: **Berchtold, Lorenz, Dr. Dipl. − Ing.**
**Grünaustrasse 3**
**W − 6450 Hanau 9(DE)**
Erfinder: **Schittny, Stefan Ulrich, Dr.**
**Dipl. − Ing.**
**Rannenbergring 39**
**W − 8755 Alzenau − Kälberau(DE)**

**Beschreibung**

Die Erfindung betrifft ein Target für Magnetron – Kathodenzerstäubungsanlagen aus einer ferromagnetischen Legierung, deren Phasendiagramm eine kubische und eine hexagonale Phase aufweist, wobei bei der Betriebstemperatur des Targets im Gleichgewichtszustand die hexagonale Phase vorliegt, durch kinetische Hemmnisse aber noch große Teile an kubischen Gefügebestandteilen anwesend sein können (vgl. EP – A – 0 252 478).

Beim Magnetron – Kathodenzerstäuben werden zur Optimierung des Zerstäubungsprozesses Permanentmagnete hinter dem Target (Kathode) so angeordnet, daß sich vor dem Target, im Entladungsraum, ein Magnetfeld ausbildet, durch das das Entladungsplasma lokalisiert wird. Der Bereich der Targetoberfläche, über dem das Plasma lokalisiert ist, wird bevorzugt zerstäubt, wodurch sich dort ein Erosionsgraben bildet.

Bei ferromagnetischen Targets treten dabei hauptsächlich zwei Probleme auf:

Erstens wird der magnetische Fluß der Permanentmagnete im Target gebündelt, so daß nur ein geringer Fluß in den Entladungsraum austreten kann. Dieses Problem erfordert daher die Verwendung sehr dünner ferromagnetischer Targets.

Zweitens bewirkt die lokale Querschnittsabnahme des Targets während der Kathodenzerstäubung (Erosionsgraben) bei ferromagnetischen Targets einen zunehmenden Magnetfluß direkt über dem Erosionsgraben.

Dadurch tritt lokal eine höhere Ionisierungswahrscheinlichkeit des Zerstäubergases und lokal eine höhere Zerstäubungsrate auf, mit der Folge, daß der Erosionsgraben sehr eng wird, verbunden mit einer nur geringen Materialausbeute des Targets.

Verbesserte Magnetfeldgeometrien und ein höherer Magnetfelddurchgriff können durch aufwendige Targetkonstruktionen erreicht werden. Durch Schlitze im Target, senkrecht zur Richtung des Magnetfeldes, kann der magnetische Widerstand im Target erhöht werden und ein größeres Feld im Entladungsraum erreicht werden (K. Nakamura et al. IEEE Transactions on Magnetics 18 (1982) 1080).

Kukla et al (IEE Transactions on Magnetics 23 (1987) 137) beschreiben eine Kathode für ferromagnetische Materialien, die aus mehreren Einzeltargets besteht, die in zwei Ebenen übereinander angeordnet sind, um ein höheres Magnetron – Magnetfeld zu erreichen. Diese Konstruktionen sind jedoch teuer und erschweren die Magnetron – Kathodenzerstäubung.

Es war daher Aufgabe der vorliegenden Erfindung, ein Target für Magnetron – Kathodenzerstäubungsanlagen aus einer ferromagnetischen Legierung zu entwickeln, deren Phasendiagramm eine kubische und eine hexagonale Phase aufweist, wobei bei der Betriebstemperatur des Targets im Gleichgewichtszustand die hexagonale Phase vorliegt, durch kinetische Hemmnisse aber noch große Teile an kubischen Gefügebestandteilen anwesend sein können. Bei diesem Target sollte ohne aufwendige konstruktive Maßnahmen eine größere Dicke und eine höhere Materialausnutzung erreichbar sein.

Diese Aufgabe wird erfindungsgemäß dadurch gelöst, daß der Mengenanteil an hexagonaler Phase größer ist als der Mengenanteil an kubischer Phase und daß die hexagonale Phase mit der hexagonalen Prismenachse (0001) bevorzugt senkrecht zur Targetoberfläche ausgerichtet ist.

Vorzugsweise verwendet man Targets, bei denen die Röntgenrückstreuintensität des hexagonalen (0001) – Bragg – Reflexes, gemessen mit $Mo – K_\alpha$ – Strahlung, senkrecht zur Targetebene um mehr als einen Faktor 1,5 größer ist als die mittlere Röntgenintensität, gemittelt über den gesamten Halbraum über der Targetebene. Besonders gute Targets erhält man, wenn die Röntgenrückstreuintensität des (0001) – Reflexes mindestens um einen Faktor 2,5 größer ist als die mittlere Röntgenintensität.

Für diese Targets verwendet man vorzugsweise Legierungen mit mehr als 60 Gew % Kobalt.

Die günstigen Eigenschaften dieser Targets lassen sich erreichen, wenn bei den entsprechenden Legierungen ein höherer Mengenantei an hexagonaler Phase eingestellt wird, als er durch stetige Abkühlung von einer Glühtemperatur oberhalb der Phasenumwandlungstemperatur erreichbar ist, sofern das Targetmaterial bei Zimmertemperatur nicht ohnehin vollständig hexagonal ist. Außerdem muß dem hexagonalen Phasenanteil eine bevorzugte Orientierung gegeben werden und zwar so, daß die hexagonalen Prismenachsen bevorzugt senkrecht zur Targetoberfläche stehen (000 1 – Fasertextur).

Es zeigte sich überraschenderweise, daß bereits eine geringe (000 1) – Fasertextur zu erheblich besseren magnetischen Eigenschaften des Targets in Bezug auf den Feldlinienverlauf beim Magnetronsputtern führt. Zur Charakterisierung der magnetischen Targeteigenschaften wurden die Magnetfeldkomponenten parallel zur Targetfläche gemessen, die man an einer typischen Sputterkathode mit Permanentmagneten (Feldstärke unmittelbar über dem Magnet: 240 KA/m) erhält.

In der Tabelle sind die Magnetfeldstärken, die man unmittelbar über der Targetoberfläche in der Mitte zwischen den beiden Permanentmagnete mißt für hexagonale bzw. teilweise hexagonale Targetmaterialien aufgeführt. Weiterhin ist in der Tabelle die Breite des Bereichs angegeben, in dem die Feldstärke um 1o % vom Maximalwert abnimmt. Es zeigt sich, daß die Materialzustände, die durch eine Kaltverformung einen höheren hexagonalen Gefügeanteil erhalten haben und deren hexagonale Prismenachsen bevorzugt senk‒ recht zur Targetoberfläche ausgerichtet wurden, eine höhere Maximalfeldstärke vor dem Target haben sowie einen breiteren homogenen Magnetfeldbereich vor dem Target.

Der höhere Magnetfelddurchgriff erlaubt die Verwendung dickerer Targets zumal die relative Zunahme des Magnetron‒Magnetfeldes mit zunehmender Dicke größer wird. Der breitere homogene Magnetfeldbe‒ reich im anisotropen Zustand führt zu einem breiteren Anfangserosionsgraben, so daß eine höhere Materialausnutzung des Targets beim Zerstäubungsprozeß erreicht wird.

Die Legierungen 1 und 3 weisen noch einen hohen kubischen Phasenanteil von etwa 50 % auf und sind nicht ausgerichtet, während in den Legierungen 2 und 4 durch eine Kaltverformung der hexagonale Phasenanteil erhöht und gleichzeitig eine Ausrichtung der hexagonalen Prismenachsen vorgenommen wurde. Die Legierungen 5 ‒ 17 besitzen zwar ein hexagonales Gefüge, aber keine Ausrichtung, während bei den Legierungen 6 und 8 eine Ausrichtung der hexagonalen Prismenachsen durch eine Kaltverformung vorgenommen wurde, was sich in den höheren Werten der Röntgenrückstreuintensität des hexagonalen (0001)‒Reflexes ausdrückt.

Die Herstellung der Targets erfolgte durch Schmelzen der Legierung in einem Elektronenstrahlofen, Schmieden des Gußbarrens bei 800 bis 1200° C und Warmwalzen bei 800 bis 1200° C. Die Targets der Legierungen 1, 3, 5 und 7 wurden anschließend eine halbe Stunde bei 1200° C geglüht und langsam abkühlen lassen, während die Targets der Legierungen 2, 4, 6 und 8 in Wasser abgeschreckt und anschließend unterhalb 400° C kaltverformt wurden.

Tabelle

| Nr. | Zusammensetzung (at %) | | | Dicke (mm) | Kaltverformungsgrad % | hexagonaler Anteil (%) | relative Röntgenrückstreuintensität (000-1)-Reflex | $H_{max}$ (kA/m) | 10%ige Abnahme (mm) |
| --- | --- | --- | --- | --- | --- | --- | --- | --- | --- |
| | Co | Ni | Cr | | | | | | |
| 1 | 62,5 | 30 | 7,5 | 2 | 0 | 50 | 1,0 | 36 | 51 |
| 2 | 62,5 | 30 | 7,5 | 2 | 50% | 80 | ca. 1,9 | 48 | 72 |
| 3 | 62,5 | 30 | 7,5 | 4 | 0 | 50 | 1,0 | 10 | 49 |
| 4 | 62,5 | 30 | 7,5 | 4 | 50% | 80 | ca. 1,9 | 38 | 67 |
| 5 | 74 | 18 | 8 | 2,5 | 0 | ca. 100 | 1,2 | 38 | 56 |
| 6 | 74 | 18 | 8 | 2,5 | 50% | 100 | 2,5 | 46 | 71 |
| 7 | 80 | 20 | 0 | 2,5 | 0 | ca. 100 | 1,1 | 32 | 55 |
| 8 | 80 | 20 | 0 | 2,5 | 50% | 100 | 2,7 | 40 | 74 |

**Patentansprüche**

1. Target für Magnetron – Kathodenzerstäubungsanlagen aus einer ferromagnetischen Legierung, deren Phasendiagramm eine kubische und eine hexagonale Phase aufweist, wobei bei der Betriebstemperatur des Targets im Gleichgewichtszustand die hexagonale Phase vorliegt, durch kinetische Hemmnisse aber noch große Teile an kubischen Gefügebestandteilen anwesend sein können, dadurch gekennzeichnet, daß der Mengenanteil an hexagonaler Phase größer ist als der Mengenanteil an kubischer Phase, und daß die hexagonale Phase mit der hexagonalen Prismenachse (0001) bevorzugt senkrecht zur Targetoberfläche ausgerichtet ist.

2. Target nach Anspruch 1, dadurch gekennzeichnet, daß die Röntgenrückstreuintensität des hexagonalen (0001) – Bragg – Reflexes, gemessen mit Mo – $K_\alpha$ – Strahlung, senkrecht zur Targetebene um mehr als einen Faktor 1,5 größer ist als die mittlere Röntgenintensität, gemittelt über den gesamten Halbraum über der Targetebene.

3. Target nach Anspruch 1 und 2 dadurch gekennzeichnet, daß die Röntgenrückstreuintensität des (0001) – Reflexes mindestens um einen Faktor 2,5 größer ist als die mittlere Röntgenintensität.

4. Target nach Anspruch 1 bis 3 dadurch gekennzeichnet, daß es aus einer Kobaltlegierung und mehr als 60 Gew % Kobalt besteht.

## Claims

1. Target for magnetron – cathode sputtering devices made of a ferromagnetic alloy, the phase diagram of which has a cubic and a hexagonal phase, wherein at the operating temperature of the target the hexagonal phase is present in the equilibrium state, however as a result of kinetic impediments large proportions of cubic structure components may still be present, characterised in that the quantity proportion of hexagonal phase is larger than the proportion of cubic phase and in that the hexagonal phase with the hexagonal prism axis (0001) is preferably orientated to the target surface perpendicularly.

2. Target as claimed in claim 1, characterised in that the X – ray back – scattering intensity of the hexagonal (0001) Bragg reflex, measured with Mo – $K_\alpha$ radiation perpendicularly to the plane of the target, is more than 1.5 times greater than the mean X – ray intensity averaged over the entire space above the plane of the target.

3. Target as claimed in claims 1 and 2, characterised in that the X – ray back – scattering intensity of the (0001) reflex is at least 2.5 times greater than the mean X – ray intensity.

4. Target as claimed in claims 1 to 3, characterised in that it consists of a cobalt alloy and more than 60% by weight cobalt.

## Revendications

1. Cible pour installations d'atomisation cathodique par magnétron à base d'alliage ferromagnétique, dont le diagramme de phases possède une phase cubique et une phase hexagonale, dans laquelle à la température de fonctionnement de la cible la phase hexagonale se présente à l'état d'équilibre et à cause des empêchements cinétiques cependant encore de grands morceaux en constituants structurels cubiques peuvent être présents, caractérisée en ce que la fraction de quantité en phase hexagonale est plus grande que la fraction de quantité en phase cubique, et en ce que la phase hexagonale est orientée avec l'axe des prismes hexagonaux (0001) de préférence perpendiculairement à la surface de la cible.

2. Cible selon la revendication 1 caractérisée en ce que l'intensité de la rétro – diffusion aux rayons X, de la réflexion Bragg (0001) hexagonale, mesurée avec le rayonnement Mo – $K\alpha$ perpendiculaire au plan de la cible, est plus grande de plus d'un facteur 1,5 que l'intensité moyenne des rayons X, déterminée sur la totalité du demi – espace au – dessus du plan de la cible.

3. Cible selon la revendication 1 et 2, caractérisée en ce que l'intensité de la rétrodiffusion de la réflexion (0001) est plus grande au moins d'un facteur 2,5 que l'intensité moyenne des rayons X.

4. Cible selon les revendications 1 à 3, caractérisée en ce qu'elle est formée d'un alliage de cobalt et de plus de 60 % en poids de cobalt.